# EUROPEAN PATENT APPLICATION

(11) **EP 4 801 211 A1**
(43) Date of publication of application: **02.09.2026**
(21) Application number: 26158508.7
(22) Date of filing: 13.02.2026
(51) Int. Cl.: H05K 7/20

(54) **LIQUID COOLING CONTROL SYSTEM AND ITS CONTROL METHOD**

(30) Priority: 26.02.2025 US 202563763275 P; 23.09.2025 CN 202511360076
(71) Applicant: Lite-On Technology Corporation, Taipei City 11492 (TW)
(72) Inventor: CHIU, Yung-Chang, 11492 Taipei City (TW); FANG, Tzu-Cheng, 11492 Taipei City (TW); LIN, Chih-Chueh, 11492 Taipei City (TW)
(74) Representative: Bals & Vogel Patentanwälte PartGmbB

(57) **Abstract**

The disclosure provides a liquid cooling control system (1) and its control method. The liquid cooling control system (1) includes a liquid storage tank (10), a first liquid pipeline (20), a second liquid pipeline (30), a radiator (40), a first circulation pump (50), an electric fan (60), a first temperature sensor (80), and a control device (90). The radiator (40) has a heat dissipation conduit (42). The first temperature sensor (80) is disposed within the heat dissipation conduit (42) to sense the temperature of the coolant within the heat dissipation conduit (42) and generate a first temperature sensing signal (T1). The first temperature sensor (80) sends the first temperature sensing signal (T1) to the control device (90), and the control device (90) controls the rotational speed of the electric fan according to the first temperature sensing signal (T1), allowing the electric fan to perform air cooling and heat dissipation on the radiator (40) with different intensities. It has the advantages of high stability and high heat exchange efficiency.

## Description

### CROSS-REFERENCE TO RELATED APPLICATION

This application claims the benefits of priorities to the U.S. Provisional Patent Application Ser. No. 63/763,275 filed on Feb. 26, 2025, and Patent Application No. 202511360076X filed on Sep. 23, 2025 in the People's Republic of China, which applications are incorporated herein by reference in their entireties.

### BACKGROUND OF THE INVENTION

### Technical Field

The disclosure relates to a cooling control system and method, and particularly to a liquid cooling control system for information processing equipment and its control method.

### Prior Art

Technology is advancing rapidly, and the demand for high-speed computing is also increasing. General information equipment, such as servers, generates a large amount of heat during operation. Overheating may cause slower operation speeds or system crashes, which creates a certain requirement for high-efficiency heat dissipation. Conventional servers usually dissipate heat through airflow. However, when the cabinet temperature rises rapidly, the existing air-cooling heat dissipation no longer meets the requirements. A liquid cooling control system is a heat exchange system that uses a liquid medium. Because the thermal conductivity of a liquid medium is much higher than that of a traditional air medium, this technology is considered one of the mainstream technologies for heat dissipation in high-power systems in the future. However, when the heat load, ambient temperature, or heat dissipation system conditions change abruptly, the liquid medium's slow control response speed prevents it from quickly reaching the set thermal equilibrium point. This can lead to system overheating, consequently affecting the component's lifespan, or more seriously, it may cause the system to trigger over-temperature protection, leading to the severe loss of the entire system shutting down.

The "Background Art" section is only intended to help in understanding the content of the disclosure. Therefore, the content disclosed in the "Background Art" section may include some known art that does not constitute common general knowledge in the field to which the disclosure belongs. The content disclosed in the "Background Art" section does not represent that the content or the problem to be solved by one or more embodiments of the disclosure was known or recognized by those with ordinary skill in the art before the application of the disclosure.

### SUMMARY OF THE INVENTION

The disclosure provides a liquid cooling control system and its control method, which can promptly measure and improve the system's response speed, thereby avoiding system overheating.

The disclosure provides a liquid cooling control system and its control method, which features inner and outer control loops, offering the advantages of high stability and high heat exchange efficiency.

Other objects and advantages of the disclosure can be further understood from the technical features disclosed herein.

To achieve one or part or all of the above objects or other objects, the disclosure provides a liquid cooling control system, connected to an external cooling device, the liquid cooling control system comprising: a liquid storage tank, a first liquid pipeline, a second liquid pipeline, a radiator, a first circulation pump, an electric fan, a first temperature sensor and a control device, wherein the liquid storage tank is used for storing coolant; the first liquid pipeline is connected to the external cooling device and provides coolant to the external cooling device; the second liquid pipeline receives the coolant returned from the external cooling device; the radiator has an inlet end and an outlet end, wherein the inlet end is connected to the second liquid pipeline and introduces the returned coolant into a heat dissipation conduit inside the radiator, and the cooled coolant is guided out from the outlet end, the outlet end extending the heat dissipation conduit which is connected to the liquid storage tank; the first circulation pump is connected to the liquid storage tank and configured to drive the liquid in the liquid storage tank to flow toward the first liquid pipeline; the first temperature sensor is disposed within the heat dissipation conduit, sensing the temperature of the coolant within the heat dissipation conduit and generating a first temperature sensing signal; wherein the first temperature sensor sends the first temperature sensing signal to the control device, and the control device controls the rotational speed of the electric fan according to the first temperature sensing signal.

In some embodiments, the control device includes a first PID (Proportional-Integral-Derivative) control module, which calculates the rotational speed of the electric fan according to the first temperature sensing signal and a sensor target temperature.

In some embodiments, the liquid cooling control system further includes a second temperature sensor, disposed within the first liquid pipeline, sensing the temperature of the coolant within the first liquid pipeline and generating a second temperature sensing signal.

In some embodiments, the control device further includes a second PID control module. The second temperature sensor sends the second temperature sensing signal to the control device. The second PID control module calculates the sensor target temperature according to the second temperature sensing signal and a water supply target temperature.

In some embodiments, the liquid cooling control system further includes a first check valve, provided between the first circulation pump and the first liquid pipeline to prevent coolant backflow.

The disclosure further provides a liquid cooling control method, used for a controlled liquid cooling control system, the controlled liquid cooling control system is connected to an external cooling device. The controlled liquid cooling control system includes a liquid storage tank, a first liquid pipeline, a second liquid pipeline, a radiator, a first circulation pump, and an electric fan. The liquid storage tank is used for storing a coolant. The first liquid pipeline is connected to the external cooling device and provides coolant to the external cooling device. The second liquid pipeline receives the coolant returned from the external cooling device. The radiator has an inlet end and an outlet end. The inlet end is connected to the second liquid pipeline and introduces the returned coolant into a heat dissipation conduit inside the radiator, and the cooled coolant is guided out from the outlet end. The outlet end extends the heat dissipation conduit, which is connected to the liquid storage tank. The first circulation pump is connected to the liquid storage tank and is configured to drive the liquid in the liquid storage tank to flow toward the first liquid pipeline. The liquid cooling control method includes the following steps: sensing the temperature of the coolant within the heat dissipation conduit and generating a first temperature sensing signal through a first temperature sensor; inputting the first temperature sensing signal and a sensor target temperature into a first PID (Proportional-Integral-Derivative) control module; and the first PID control module calculating the rotational speed of the electric fan according to the first temperature sensing signal and the sensor target temperature.

In some embodiments, the liquid cooling control method further includes: sensing the temperature of the coolant within the first liquid pipeline and generating a second temperature sensing signal through a second temperature sensor.

In some embodiments, the liquid cooling control method further includes: inputting the second temperature sensing signal and a water supply target temperature into a second PID control module; the second PID control module calculating and outputting the sensor target temperature according to the second temperature sensing signal and the water supply target temperature.

The disclosure provides a liquid cooling control system and its control method, by arranging a first temperature sensor within the heat dissipation conduit inside the radiator. The first temperature sensor sends the first temperature sensing signal to the control device, and the control device controls the rotational speed of the electric fan according to the first temperature sensing signal. The disclosure can timely measure the temperature of the coolant within the heat dissipation conduit and promptly adjust the rotational speed of the electric fan disposed outside the radiator. By the electric fan performing air cooling and heat dissipation on the radiator with different intensities, the system can measure promptly and improve the system's response speed, thereby avoiding system overheating. Furthermore, the liquid cooling control system and its control method provided by the disclosure feature inner and outer control loops, offering the advantages of high stability and high heat exchange efficiency.

### BRIEF DESCRIPTION OF DRAWINGS

The accompanying drawings, which are incorporated in and constitute a part of this specification, illustrate exemplary embodiments of the disclosure and, together with the description, serve to explain the principles of the disclosure. They do not constitute an undue limitation of the disclosure. In the drawings:
Fig. 1 is a schematic structural diagram of the liquid cooling control system of the disclosure.
Fig. 2 is a schematic diagram of an embodiment of the liquid cooling control device of the disclosure.
Fig. 3 is a flowchart of an embodiment of the liquid cooling control method of the disclosure.

### DETAILED DESCRIPTION OF THE INVENTION

The aforementioned and other technical contents, features, and effects of the disclosure will be clearly presented in the following detailed description of a preferred embodiment with reference to the accompanying drawings. Directional terms used in the following embodiments, such as up, down, left, right, front, or back, etc., are only in reference to the directions in the accompanying drawings. Therefore, the directional terms used are for illustration and are not intended to limit the disclosure.

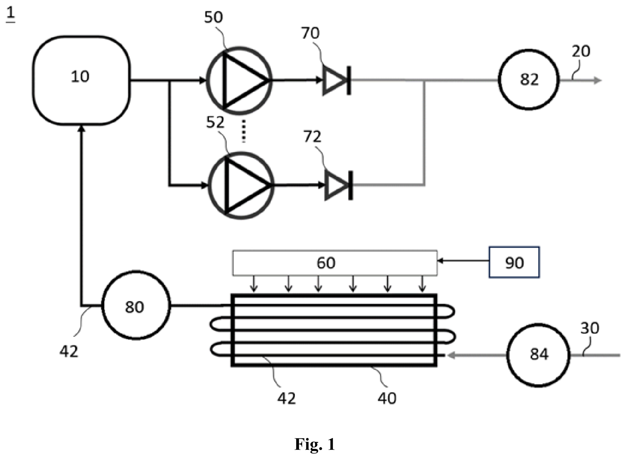

Fig. 1 is a schematic structural diagram of the liquid cooling control system of the disclosure. Fig. 1 shows a liquid cooling control system 1, connected to an external cooling device (not shown). The liquid cooling control system 1 includes: a liquid storage tank 10, a first liquid pipeline 20, a second liquid pipeline 30, a radiator 40, a first circulation pump 50, an electric fan 60, a first temperature sensor 80, and a control device 90. The liquid storage tank 10 is used for storing coolant, which may be, for example, pure water, but is not limited thereto. The first liquid pipeline 20 is connected to the external cooling device (not shown) and provides coolant to the external cooling device. It should be noted that the external cooling device may be, for example, a cold plate or a water block disposed on an external server, to carry away the heat energy dissipated by internal components of the external server for cooling and temperature reduction. The second liquid pipeline 30 receives the coolant returned from the external cooling device. The radiator 40 has an inlet end and an outlet end. The inlet end is connected to the second liquid pipeline 30 and introduces the returned coolant into the heat dissipation conduit 42 inside the radiator 40, and the cooled coolant is guided out from the outlet end. Since the returned coolant from the external cooling device flows through the heat dissipation conduit 42, heat of the returned coolant is dissipated. Thus, the coolant flowing through the outlet of the radiator 40 has lower temperature than the returned coolant, and we refer to it as the cooled coolant. It should be noted that the heat dissipation conduit 42 extending from the outlet end of the radiator 40 is connected to the liquid storage tank 10. The first circulation pump 50 is connected to the liquid storage tank 10 and is configured to drive the liquid in the liquid storage tank 10 to flow toward the first liquid pipeline 20, completing an internal circulation. The heat dissipation conduit 42 is provided with the first temperature sensor 80 to sense the temperature of the coolant within the heat dissipation conduit 42 and generate a first temperature sensing signal. The first temperature sensor 80 sends the first temperature sensing signal to the control device 90. For example, the first temperature sensor 80 may send the first temperature signal to the control device 90 through a wireless connection or through a wireless communication link. The control device 90 controls the rotational speed of the electric fan 60 according to the first temperature sensing signal, allowing the electric fan 60 to perform air cooling and heat dissipation on the radiator 40 with different intensities, thereby measuring and adjusting the temperature promptly, improving the system's response speed, and avoiding system overheating.

As shown in Fig. 1, in some embodiments, a first check valve 70 is provided between the first circulation pump 50 and the first liquid pipeline 20 to prevent coolant backflow. The disclosure may also optionally include a second circulation pump 52 arranged in parallel with the first circulation pump 50. The second circulation pump 52 is connected to the liquid storage tank 10 and is configured to drive the liquid in the liquid storage tank 10 to flow toward the first liquid pipeline 20. Similarly, a second check valve 72 may be provided between the second circulation pump 52 and the first liquid pipeline 20 to prevent coolant backflow. It should be noted that the embodiments of the disclosure are not limited thereto, and multiple parallel circulation pumps and a corresponding number of check valves may be provided to enhance the overall circulation efficiency of the system.

As shown in Fig. 1, in some embodiments, a second temperature sensor 82 is provided on the first liquid pipeline 20 to sense the temperature of the coolant at the first liquid pipeline 20. A return water temperature sensor 84 is disposed on the second liquid pipeline 30 to sense the temperature of the coolant at the second liquid pipeline 30. The exterior of the radiator 40 may be, for example, heat dissipation fins, but is not limited thereto. The radiator 40 may include a casing, an internal heat dissipation conduit, etc. Multiple radiators 40 may also be used together, and the radiator 40 may have multiple heat sinks, multiple heat dissipation fins, etc., which may be provided. It should be noted that the return water temperature sensor 84 may sense the temperature of the fluid returning to the system at the second liquid pipeline 30. The returned liquid at the second liquid pipeline 30 may be fluid provided by a device (such as a heat-generating server) for liquid cooling, and the temperature sensed by the return water temperature sensor 84 is usually higher than the temperature sensed by the second temperature sensor 82.

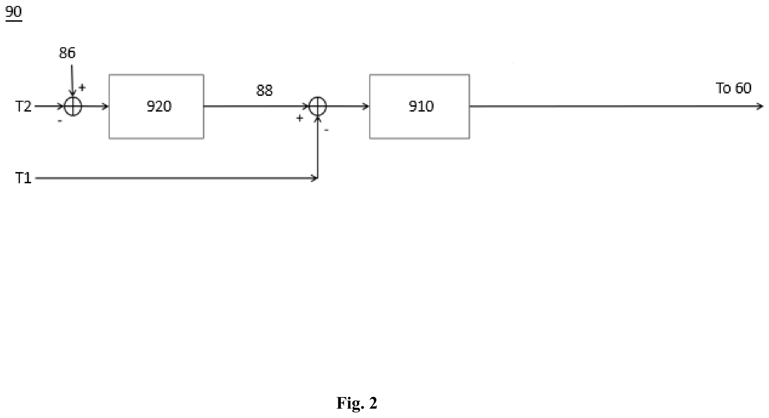

Fig. 2 is a schematic diagram of an embodiment of the liquid cooling control device of the disclosure. Please refer to Fig. 1 simultaneously. As shown in Fig. 2, the control device 90 includes a first PID (Proportional-Integral-Derivative) control module 910, which can calculate the rotational speed of the electric fan according to the first temperature sensing signal T1 and the sensor target temperature 88. The liquid cooling control system 1 further includes a second temperature sensor 82, disposed within the first liquid pipeline 20 to sense the temperature of the coolant within the first liquid pipeline 20 and generate a second temperature sensing signal T2. The control device 90 further includes a second PID control module 920. The second PID control module 920 calculates the sensor target temperature 88 according to the second temperature sensing signal T2 and the water supply target temperature 86. The water supply target temperature 86 is a target temperature for the coolant which flows through the first liquid pipeline 20 and provided to the external cooling device. For example, the control device 90 or the second PID control module 920 may set the temperature value of the water supply target temperature 86. In some embodiments, the water supply target temperature 86 may also be set by a user or operator of the liquid cooling control system 1. The resulting sensor target temperature 88 is inputted into the first PID control module 910 of the liquid cooling control system 1. The first PID control module 910 receives the sensor target temperature 88 and the first temperature sensing signal T1 and calculates the rotational speed of the electric fan 60. Specifically, the second PID control module 920 may calculate the sensor target temperature 88 according to the second temperature sensing signal T2 and the water supply target temperature 86. The difference between the water supply target temperature 86 and the second temperature sensing signal T2 may be input to the second PID control module 920. The first PID control module 910 may calculate the rotational speed of the electric fan 60 according to the first temperature sensing signal T1 generated by the first temperature sensor 80 and the sensor target temperature 88. The heat dissipation of the liquid cooling control system 1 is regulated by controlling the rotational speed of the electric fan 60, which blows air toward the radiator 40. The disclosure uses the first temperature sensor 80 to react or measure the effect of the electric fan 60's rotational speed change on the liquid temperature more quickly. Because this control method calculates and adjusts the sensor target temperature 88, it avoids over-adjustment of the temperature at the outlet of the first liquid pipeline 20 (as sensed by the second temperature sensor 82) of the liquid cooling control system 1.

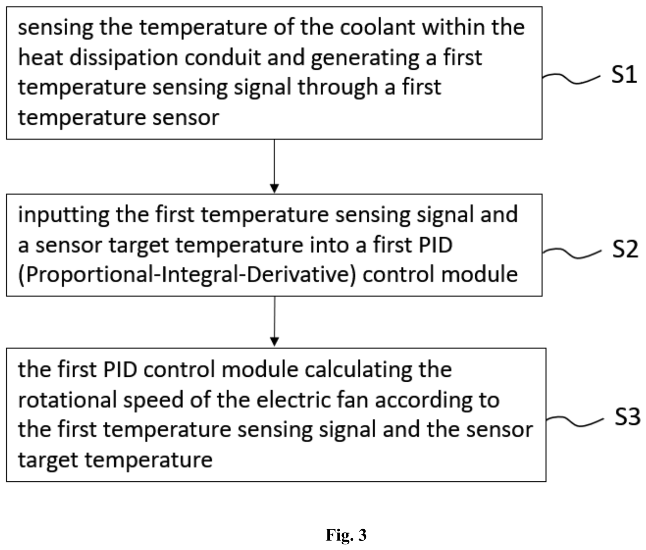

Fig. 3 is a flowchart of an embodiment of the liquid cooling control method of the disclosure. Please refer to Figs. 1 and 2 simultaneously. Fig. 3 shows a liquid cooling control method for controlling a liquid cooling control system. The controlled liquid cooling control system is connected to an external cooling device (not shown). The controlled liquid cooling control system includes a liquid storage tank 10, a first liquid pipeline 20, a second liquid pipeline 30, a radiator 40, a first circulation pump 50, and an electric fan 60. The liquid storage tank 10 is used for storing coolant. The first liquid pipeline 20 is connected to the external cooling device and provides coolant to the external cooling device. The second liquid pipeline 30 receives the coolant returned from the external cooling device. The radiator 40 has an inlet end and an outlet end. The inlet end is connected to the second liquid pipeline 30 and introduces the returned coolant into the heat dissipation conduit 42 inside the radiator 40. The cooled coolant is guided out from the outlet end. Since the returned coolant from the external cooling device flows through the heat dissipation conduit 42, heat of the returned coolant is dissipated. Thus, the coolant flowing through the outlet of the radiator 40 has lower temperature than the returned coolant, and we refer to it as the cooled coolant. The outlet end extends the heat dissipation conduit 42, which is connected to the liquid storage tank 10. The first circulation pump 50 is connected to the liquid storage tank 10 and is configured to drive the liquid in the liquid storage tank 10 to flow toward the first liquid pipeline 20. The liquid cooling control method includes the following steps: sensing the temperature of the coolant within the heat dissipation conduit and generating a first temperature sensing signal through a first temperature sensor (Step S1); inputting the first temperature sensing signal and a sensor target temperature into a first PID (Proportional-Integral-Derivative) control module (Step S2); and the first PID control module calculating the rotational speed of the electric fan according to the first temperature sensing signal and the sensor target temperature (Step S3).

Please refer to Figs. 1 to 3 simultaneously. In one embodiment, Step S1 primarily involves sensing the temperature of the coolant within the heat dissipation conduit 42 and generating the first temperature sensing signal T1 through the first temperature sensor 80. Furthermore, the liquid cooling control method of the disclosure may include: the second temperature sensor 82 sensing the temperature of the coolant within the first liquid pipeline 20 and generating the second temperature sensing signal T2; the second temperature sensing signal T2 and the water supply target temperature 86 are inputted into the second PID control module 920; the second PID control module 920 calculates the sensor target temperature 88 according to the second temperature sensing signal T2 and the water supply target temperature 86.

Please refer to Figs. 1 to 3 simultaneously. In one embodiment, the sensor target temperature 88 obtained by the second PID control module 920 according to the second temperature sensing signal T2 and the water supply target temperature 86 is inputted into the first PID control module 910 of the liquid cooling control system 1. The first PID control module 910 receives the sensor target temperature 88 and the first temperature sensing signal T1, and then calculates the rotational speed of the air-cooling electric fan 60. The detailed description has been provided in the preceding paragraphs and will not be repeated here.

It should be noted that the position of the first temperature sensor 80 in the disclosure is not limited. In other words, the first temperature sensor 80 may be disposed within the heat dissipation conduit 42 inside the radiator 40 or within the heat dissipation conduit 42 outside the radiator 40.

In summary, the disclosure provides a liquid cooling control system and its control method. In the liquid cooling control system, a first temperature sensor is disposed within the heat dissipation conduit of the radiator to timely sense the temperature of the coolant within the heat dissipation conduit. The control device is used to promptly adjust and control the rotational speed of the electric fan disposed outside the radiator. By the electric fan performing air cooling and heat dissipation on the radiator with different intensities, the system can measure promptly and improve the system's response speed, thereby avoiding system overheating. Furthermore, the liquid cooling control method provided by the disclosure features two control loops, an inner loop and an outer loop, where the inner loop can provide a faster temperature control response than the outer loop, offering the advantages of high stability and high heat exchange efficiency.

However, the above descriptions are merely preferred embodiments of the disclosure, and should not be used to limit the scope of the disclosure. Any simple equivalent changes and modifications made according to the scope of the patent application and the content of the description of the invention shall still fall within the scope of the patent coverage of the disclosure. Furthermore, any single embodiment or claim of the disclosure is not required to achieve all the objects, advantages, or features disclosed by the disclosure. In addition, the abstract and titles are only used to facilitate patent document search and are not intended to limit the scope of the claims of the disclosure. Moreover, terms such as "first," "second," etc., mentioned in this specification or claims are only used to name elements or distinguish between different embodiments or scopes, and are not intended to limit the upper or lower bound on the number of components.

## Claims

1. A liquid cooling control system (1), connected to an external cooling device, the liquid cooling control system (1) comprising:
a liquid storage tank (10), used for storing coolant;
a first liquid pipeline (20), connected to the external cooling device and providing coolant to the external cooling device;
a second liquid pipeline (30), receiving the coolant returned from the external cooling device;
a radiator (40), having an inlet end and an outlet end, wherein the inlet end is connected to the second liquid pipeline (30) and introduces the returned coolant into a heat dissipation conduit (42) inside the radiator (40), and the cooled coolant is guided out from the outlet end, the outlet end extending the heat dissipation conduit (42) is connected to the liquid storage tank (10);
a first circulation pump (50), connected to the liquid storage tank (10) and configured to drive the liquid in the liquid storage tank (10) to flow toward the first liquid pipeline (20);
an electric fan (60);
a first temperature sensor (80) disposed within the heat dissipation conduit (42), sensing the temperature of the coolant within the heat dissipation conduit (42)and generating a first temperature sensing signal (T1); and
a control device (90);
wherein the first temperature sensor (80) sends the first temperature sensing signal (T1) to the control device (90), and the control device (90) controls the rotational speed of the electric fan according to the first temperature sensing signal (T1).

2. The liquid cooling control system (1) as claimed in claim 1, wherein the control device (90) comprises a first PID (Proportional-Integral-Derivative) control module (910), which calculates the rotational speed of the electric fan according to the first temperature sensing signal (T1) and a sensor target temperature (88).

3. The liquid cooling control system (1) as claimed in claim 2, further comprising a second temperature sensor (82), disposed within the first liquid pipeline (20), sensing the temperature of the coolant within the first liquid pipeline (20) and generating a second temperature sensing signal (T2).

4. The liquid cooling control system (1) as claimed in claim 3, wherein the control device (90) further comprises a second PID control module (920);
wherein the second temperature sensor (82) sends the second temperature sensing signal (T2) to the control device (90), and the second PID control module (920) calculates the sensor target temperature (88) according to the second temperature sensing signal (T2) and a water supply target temperature (86).

5. The liquid cooling control system (1) as claimed in claim 1, further comprising a first check valve (70) provided between the first circulation pump (50) and the first liquid pipeline (20) to prevent coolant backflow.

6. The liquid cooling control system (1) as claimed in claim 1, further comprising a return water temperature sensor (84) disposed on the second liquid pipeline (30) to sense the temperature of the coolant at the second liquid pipeline (30).

7. The liquid cooling control system (1) as claimed in claim 1, wherein the radiator (40) has heat dissipation fins.

8. The liquid cooling control system (1) as claimed in claim 1, further comprising a second circulation pump (52), the second circulation pump (52) arranged in parallel with the first circulation pump (50), and the second circulation pump (52) connected to the liquid storage tank (10) and configured to drive the liquid in the liquid storage tank (10) to flow toward the first liquid pipeline (20).

9. The liquid cooling control system (1) as claimed in claim 8, further comprising a first check valve (70) provided between the first circulation pump (50) and the first liquid pipeline (20) to prevent coolant backflow, and a second check valve (72) provided between the second circulation pump (52) and the first liquid pipeline (20) to prevent coolant backflow.

10. A liquid cooling control method, used for a controlled liquid cooling control system (1), the controlled liquid cooling control system (1) connected to an external cooling device, the controlled liquid cooling control system (1) comprising a liquid storage tank (10), a first liquid pipeline (20), a second liquid pipeline (30), a radiator (40), a first circulation pump (50), and an electric fan (60), the liquid storage tank (10) used for storing coolant, the first liquid pipeline (20) connected to the external cooling device and provides coolant to the external cooling device, the second liquid pipeline (30) receiving the coolant returned from the external cooling device, the radiator (40) having an inlet end and an outlet end, the inlet end connected to the second liquid pipeline (30) and introducing the returned coolant into a heat dissipation conduit (42) inside the radiator (40), and the cooled coolant guided out from the outlet end, the outlet end extending the heat dissipation conduit (42) which is connected to the liquid storage tank (10), the first circulation pump (50) connected to the liquid storage tank (10) and configured to drive the liquid in the liquid storage tank (10) to flow toward the first liquid pipeline (20), the liquid cooling control method comprising the following steps:
sensing the temperature of the coolant within the heat dissipation conduit (42) and generating a first temperature sensing signal (T1) through a first temperature sensor (80);
inputting the first temperature sensing signal (T1) and a sensor target temperature (88) into a first PID (Proportional-Integral-Derivative) control module (910); and
the first PID control module (910) calculating the rotational speed of the electric fan according to the first temperature sensing signal (T1) and the sensor target temperature (88).

11. The liquid cooling control method as claimed in claim 10, the liquid cooling control method further comprising: sensing the temperature of the coolant within the first liquid pipeline (20) and generating a second temperature sensing signal (T2) through a second temperature sensor (82).

12. The liquid cooling control method as claimed in claim 11, further comprising: inputting the second temperature sensing signal (T2) and a water supply target temperature (86) into a second PID control module (920); the second PID control module (920) calculating the sensor target temperature (88) according to the second temperature sensing signal (T2) and the water supply target temperature (86).
